# EUROPEAN PATENT SPECIFICATION

(11) **EP 0 615 147 B1**
(45) Date of publication and mention of the grant of the patent: **05.08.1998**
(21) Application number: 93103749.3
(22) Date of filing: 09.03.1993
(51) Int. Cl.: G02B 26/08, C23C 16/44

(54) **Micromechanical deformable mirror device (DMD)**
Mikromechanische, verformbare Spiegelvorrichtungen (-DMD-)
Dispositifs micromécanique à miroirs déformables (-DMD-)

(43) Date of publication of application: 14.09.1994
(73) Proprietor: TEXAS INSTRUMENTS INCORPORATED, Dallas Texas 75265 (US)
(72) Inventor: Hornbeck, Larry J., Van Alstyne, Texas 75095 (US)
(74) Representative: Schwepfinger, Karl-Heinz, Dipl.-Ing.

(56) References cited:
- EP-A- 370 311
- EP-A- 390 127
- EP-A- 510 629
- DE-C- 4 137 606
- FR-A- 2 584 083
- THIN SOLID FILMS, vol. 200, no. 2, 15 May 1991, Lausanne CH, pp. 375-384; R. JONES et al.: 'Formation of highly ordered thin films of perfluorinated carboxylic acids and azobenzenes by thermal evaporation'
- THIN SOLID FILMS, vol. 160, 1988, Lausanne CH, pp. 453-462; M. SUZUKI et al.: 'Characterization of monolayer and bilayer (polymer/monolayer) structures for their use as a lubricant'
- SOVIET PHYSICS SEMICONDUCTORS, vol. 25, no. 12, December 1991, New York US, pp. 1337-1338; D.A. ZNAMENSKII et al.: 'Photogalvanic properties of metal-Langmuir film of perfluorinated polymer-gallium arsenide structures'

## Description

### BACKGROUND OF THE INVENTION

### 1. Field of the Invention

This invention deals with micromechanical devices, more particularly with a micromechanical device as defined in the precharacterizing part of claim 2. Further, the invention relates to a method of forming protective coating on such a device.

### 2. Description of the Prior Art

A micromechanical device as mentioned above is known from EP-A-0 510 629. This document describes a micromechanical shutter device, wherein the deflectable element has a vertical shutter attached to its underside. When the electrode is addressed the movement of the deflectable element causes the shutter to raise or lower. The device has no protective coating on it.

There are many different types of micromechanical devices, three of which are micro-motors, micro-gears, and micromechanical deformable mirror devices (DMD). Micromechanical DMDs contain an activation or addressing electrode, a support post or posts, underneath a hinge or hinges, which in turn supports a deflection element suspended over the electrode. The DMDs are primarily used in the direction of light in optical systems, with a mirrored deflection element.

The operation of such devices involves activating the electrode which builds up electrostatic charge in the gap between electrode and deflection element. The deflection element then flexes on its hinge or hinges and moves towards the electrode. When the charge is removed, the deflection element returns to its undeflected position.

Contact between the operating and supporting pieces of micromechanical devices such as micro-gears and micro-motors may result in sticking. Likewise, if the deflection element of a DMD comes into contact with the electrode, it may possibly stick in the deflected position. One method of freeing the deflection element of a DMD is by the application of a voltage pulse train with a frequency around the resonant frequency of the hinge. When the pulse train ceases, the deflection element returns to its undeflected position.

This method of reset works very well. However, after many contacts between electrode and deflection element, the wear increases the effective contact area. This requires higher and higher voltages for reset.

The article "Formation of Highly Ordered Thin Films of Perfluorinated Carboxylic Acids and Azobenzenes by Thermal Evaporation" of R. Jones et al. in Thin Solid Films, Vol. 200, No. 2, 1991, pages 375-384, reports that good-quality multilayers of perfluordecanoic acid can be obtained by thermal evaporation. It is further mentioned that monolayers of fluorocarbons have been formed by evaporation. According to the article, fluorocarbons are supposed to be more resistant to chemical and biological degradation than hydrocarbons.

### SUMMARY OF THE INVENTION

It is an object of this invention to provide a passivation layer for points of contact in micromechanical devices. It is another object of this invention to provide the method in which such a layer is developed. Other objects and advantages will be obvious, and will in part appear hereinafter and will be accomplished by the present invention which provides a method of forming a protective coating on a micromechanical device as defined in claim 1.

The device according to the invention has the features of the characterizing part of claim 2.

### BRIEF DESCRIPTION OF THE DRAWINGS

For a complete understanding of the invention, and the advantages thereof, reference is now made to the following description in conjunction with the accompanying drawings, in which:

FIGURE 1a shows an undeflected prior art torsion beam DMD.

FIGURE 1b shows a deflected prior art torsion beam DMD.

FIGURE 2 shows a flow diagram of the method of this invention.

FIGURE 3a shows the molecular structure of a perfluordecanoic acid (PFDA) molecule.

FIGURE 3b shows a monolayer upon a substrate.

FIGURE 3c shows a beam tip and an electrode after passivation.

FIGURE 4 shows a single chamber deposition apparatus.

FIGURE 5 shows a dual chamber deposition apparatus.

### DETAILED DESCRIPTION OF THE INVENTION

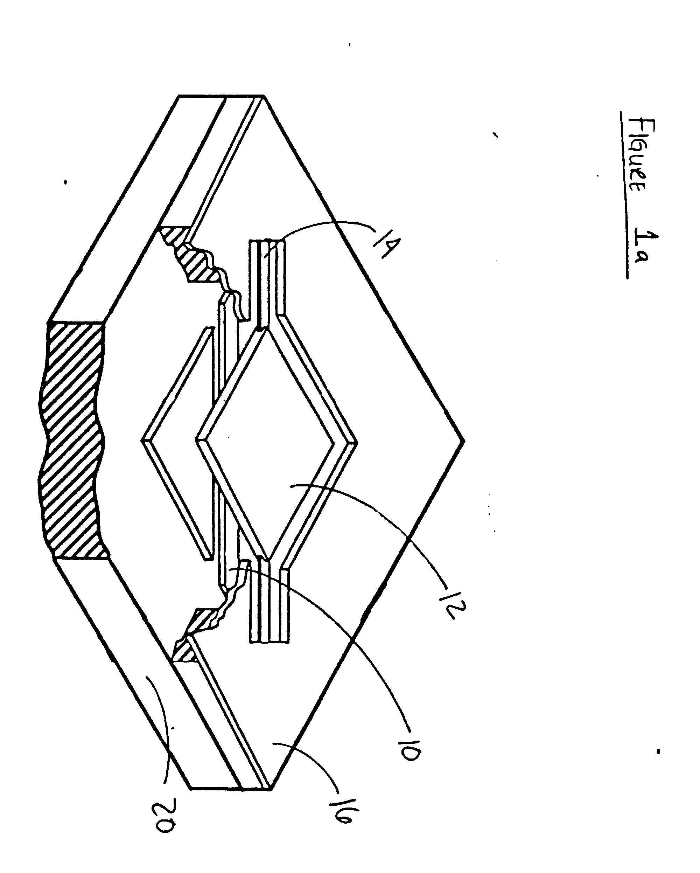

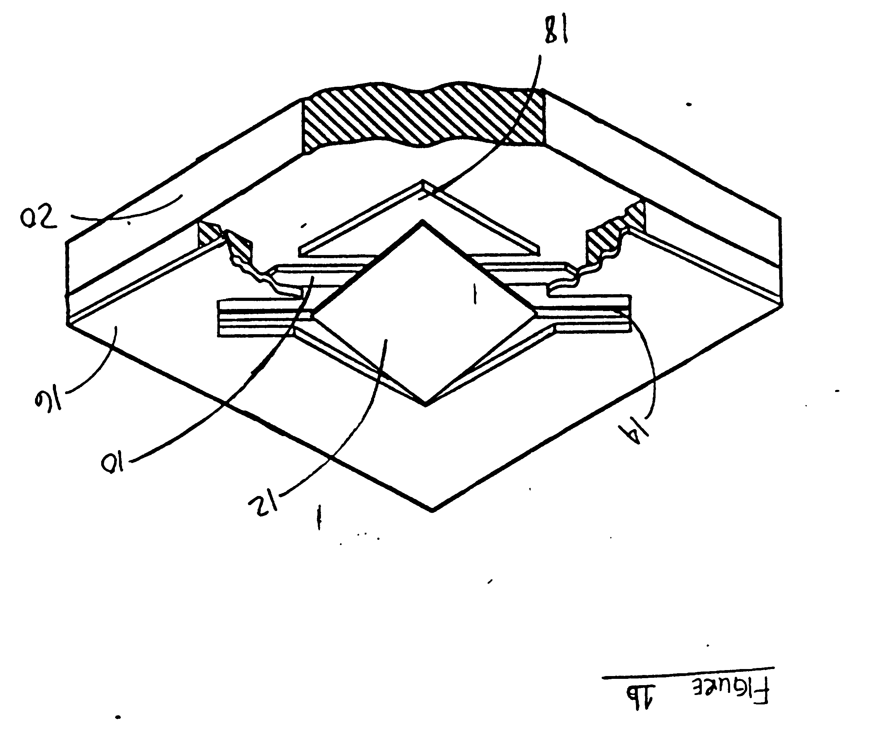

Figure 1a shows an undeflected torsion beam DMD (deformable mirror device). When address electrode 10 is activated, an electrostatic attractive force builds between the electrode and the deflection element 12. In Figure 1b, the attraction between the two causes the deflection element to bend on its hinge 14, which is supported by support layer 16. The element twists and its edge touches or lands on the substrate 20 at landing electrode 18.

The contact between the electrode 18 and the element 12 results in attractive inter-molecular forces between the two surfaces commonly referred to as Van der Waals forces. Van der Waals forces increase as the surface energy of a material increase. The ratio of the Van der Waals forces to the restorative forces in the beam increases over time. As more landings are made, the contact area between the surfaces increases, and the element has a more difficult time overcoming the increasing Van der Waals forces and breaking free of the landing electrode when the addressing electrode is deactivated by removal of the voltage. Eventually, the element cannot break free of the landing electrode. This can be overcome by application of a voltage pulse train to the landing electrode. Over time, the amount of voltage applied must be increased to compensate for increasing Van der Waals forces. Finally, the necessary amount of voltage to free the element results in too much electrostatic force on the beam, such that the element may be damaged and possibly even causing the beam to snap off of its hinge.

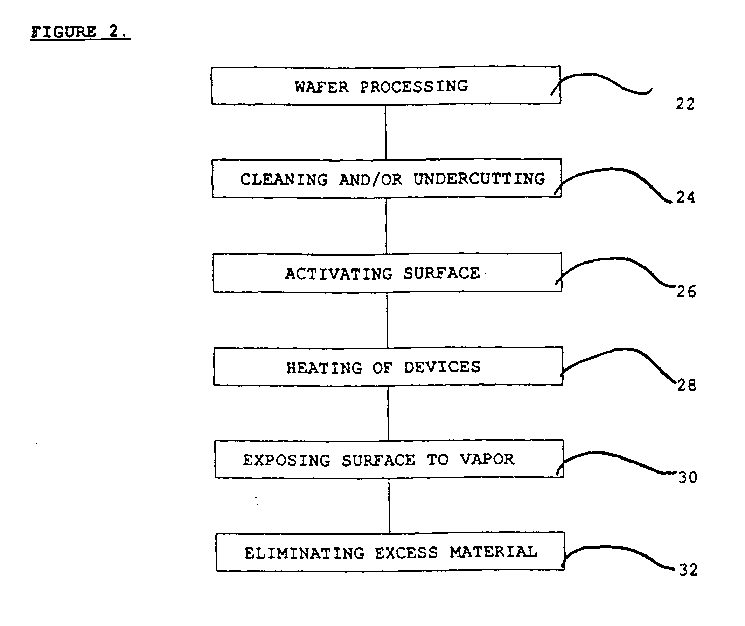

According to the present invention, a better method to eliminate problems of this sort is to passivate the devices as shown in Figure 2. The necessary processing at the wafer level is accomplished in step 22. In the case of the DMD, this involves among other things layering and etching the wafer with the electrode circuitry, the organic spacer and the mirror surface. The wafers are then divided up into chips and the process moves on to step 24.

According to step 24, the surfaces of the micromechanical device that is to be activated must be cleaned. With the DMD, in addition to cleaning the devices, the organic spacer must be undercut to allow free movement of the deflection elements upon their posts. This is typically accomplished with a plasma etch. Consequently after a plasma etch step, the cleaning may be accomplished with oxygen plasma at room temperature. Cleaning removes any organic contaminants and chemisorbed and physisorbed water from the surface. This method also eliminates the possibility of mechanical damage to the DMD, which can occur with the use of solvents and high temperature baking.

After cleaning the surfaces of the devices, the device surfaces are then activated as shown in step 26 by placing them into a oxygen/fluorine plasma. Typical conditions for this step are: Power - 100W; Pressure - 2 torr; Flow rates (NF₃ - 2 SCCM, O₂ - 180 SCCM, He - 50 SCCM); Temp - Room; and Time - 20 sec. Activation provides a high energy surface which allows the source material molecules to form into a close-packed oriented monolayer.

The heating of devices as required by step 28 can be done in many ways. A preferred method is to place the chips with the surfaces to be passivated fully exposed, and a small quantity of the source material to be used as the passivating material together in a covered glass container. In this case, powdered perfluordecanoic acid (PFDA) is placed in the container as the passivating material. This covered container is then placed in a vacuum oven. As the PFDA begins to melt, it produces a vapor that deposits upon the exposed and activated surfaces of the chips.

As shown in step 30, after the deposition is finished, the cover of the container is then removed and the oven is evacuated and continuously pumped to eliminate any excess source material. This ensures that the only PFDA left is that which is in the deposited monolayer upon the chips.

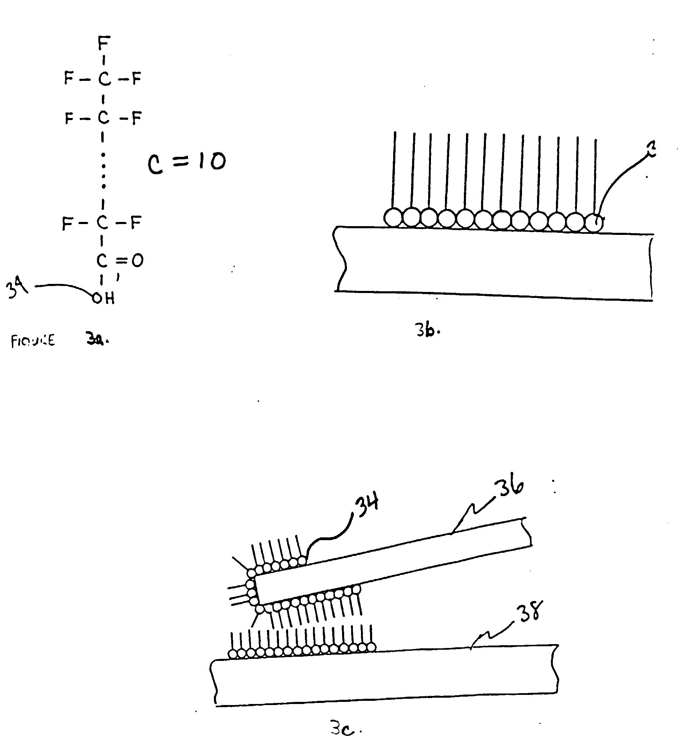

Figure 3a shows the molecular structure of a molecule of PFDA. The COOH group 34 is the polar end that will be oriented to contact the surface to be passivated. Figure 3b shows the relationship of the molecule to the substrate after passivation. The polar end 34 forms a bond with the surface, orienting the PFDA molecule accordingly. Figure 3c shows the beam 36 and the landing electrode 38 with their respective monolayers of the passivation material. These monolayers help prevent the build up of the Van der Waals forces between the two pieces, by lowering the surface energy.

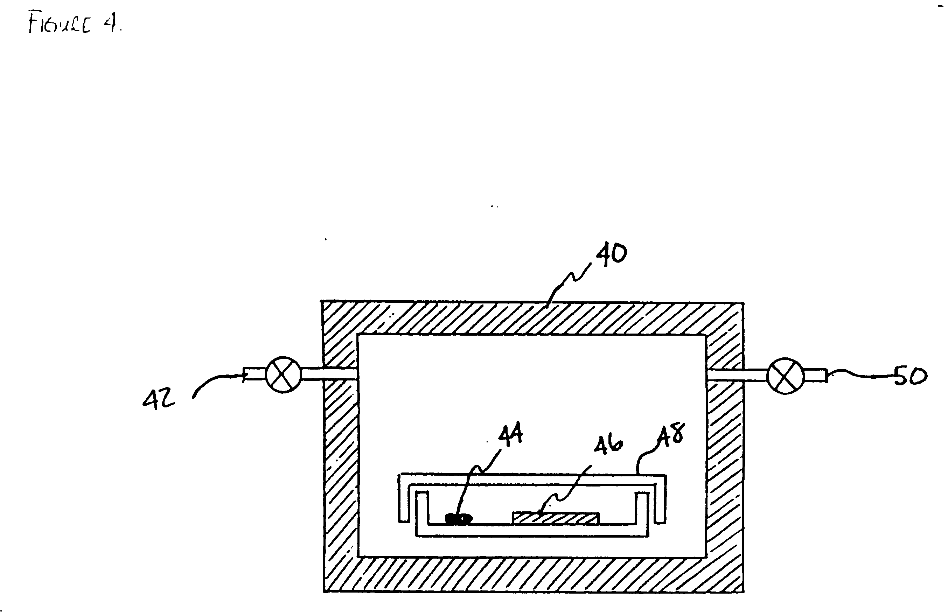

Figure 4 shows one of the many ways the vapor deposition can be accomplished. Oven 40 is preheated to 80° C. Source material 44, in this case PFDA, is placed with the chips 46 in the glass container 48. These are placed in the oven which is evacuated by valve 50, and backfilled through valve 42 with dry N₂. When the PFDA reaches its melting temperature it produces a vapor which is deposited onto the surface of the chips. The lid of the container is removed after about 5 minutes of deposition, and the oven is evacuated and continuously pumped to eliminate the excess PFDA.

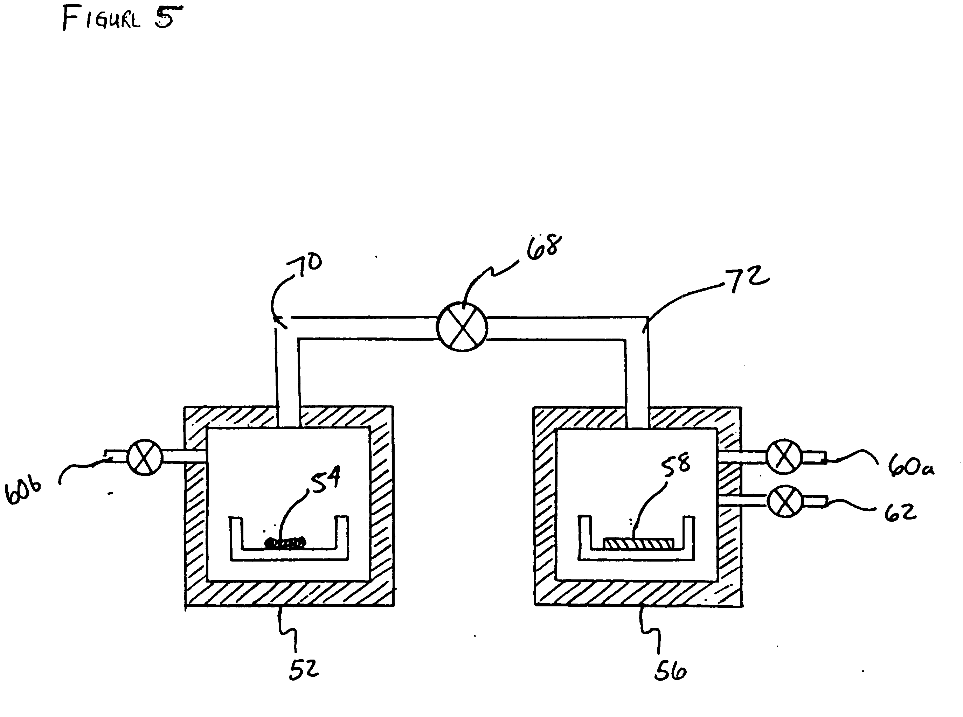

Figure 5 shows an alternate configuration for the vapor deposition process. Two ovens are used, connected by a tube containing a valve. Oven 52 contains the source 54 and oven 56 contains the chips 58. The valve 68 is opened and both chambers are evacuated. The valve is then closed. The ovens are backfilled with N₂ through valves 60a and 60b. When the source begins to vaporize, the valve is opened and the vapor allowed to travel into the second oven, along pipe 70 past the valve and into pipe 72. When the time is up, the valve is closed, and the second oven evacuated and pumped through valve 62. The only PFDA left in the second oven is that which was deposited as the monolayer.

The unique nature of the resultant monolayer produces many beneficial effects, three of which are low surface energy, low coefficient of friction, and high wear resistance. These effects result from three properties of the layer. First, the -CF₃ terminal group forms the outermost layer of the absorbed monolayer and it is this group that is responsible for the low Van der Waals force, or low surface energy and low coefficient of friction of a surface treated with such a monolayer. Second, the polar ends of the molecules are strongly adsorbed onto the substrate. Third, the molecular chains are closely packed and oriented parallel to one another so as to give stiffness to the film in a direction parallel to the substrate surface. Longer chains give greater wear resistance because, at a critical value of chain length, the monolayer undergoes a phase transition from a condensed liquid to a solid.

Thus, although there has been described to this point particular embodiments for passivation techniques, using an oriented monolayer, it is not intended that such specific references be considered as limitations upon the scope of this invention except in-so-far as set forth in the following claims.

## Claims

1. A method of forming protective coating on a micromechanical device, comprising the steps of: manufacturing a micromechanical device having a deflectable element (12) suspended on hinges (14) over at least one address electrode (10) and at least one landing electrode (18), such that when said address electrode (10) is activated, said deflectable element (12) deflects and comes to rest on said landing electrode (18); depositing said protective coating on said landing electrode (38) and said deflectable element (36) of said micromechanical device to prevent sticking between said landing electrode (38) and said deflectable element (36) of said device, wherein before the step of depositing the surface to be coated is activated by placing the device into an oxygen plasma and then heated and
said protective coating is formed by vapor depositing of perfluorodecanoic acid (PFDA) to form an oriented monolayer that prevents sticking and has high wear and abrasion resistance.

2. A micromechanical device comprising: at least one address electrode (10) on a substrate (20); at least on landing electrode (18) on said substrate (20) adjacent said address electrode (10); a support layer formed upon said substrate (20) such that at least on gap exists in said layer exposing said address electrode (10) and said landing electrode (18); at least one hinge (14) formed on said support layer such that said hinge (14) is suspended over said gap; at least one deflection element (12) formed upon said at least one hinge (14), wherein said deflection element (12) is positioned to be suspended over said gap; said device further characterized by:
an oriented monolayer of perfluorodecanoic acid (PFDA) formed upon said landing electrode (38) and said deflectable element (36), such that when said address electrode is activated and said deflection element twists about said hinge and touches said landing electrode, said landing electrode and said deflection element do not stick together, and said monolayer does not wear or scratch off of said landing electrode and said deflectable element.

## Patentansprüche

1. Verfahren zum Bilden einer Schutzbeschichtung auf einer mikromechanischen Vorrichtung, mit den folgenden Schritten: Herstellen einer mikromechanischen Vorrichtung mit einem ablenkbaren Element (12), das an Scharnieren (14) über wenigstens einer Adressenelektrode (10) und wenigstens einer Landungselektrode (18) in der Weise aufgehängt ist, daß, wenn die Adressenelektrode (10) aktiviert wird, das ablenkbare Element (12) abgelenkt wird und auf der Landungselektrode (18) zu liegen kommt; Ablagern der Schutzbeschichtung auf der Landungselektrode (38) und dem ablenkbaren Element (36) der mikromechanischen Vorrichtung, um eine Haftung zwischen der Landungselektrode (38) und dem ablenkbaren Element (36) der Vorrichtung zu verhindern, wobei vor dem Schritt des Aufbringens die zu beschichtende Oberfläche durch Anordnen der Vorrichtung in einem Sauerstoffplasma aktiviert und anschließend erwärmt wird und
die Schutzschicht durch Dampfabscheidung von Perfluordecansäure (PFDA) gebildet wird, um eine gerichtete Einzelschicht zu bilden, die eine Haftung verhindert und einen hohen Verschleiß- und Abriebwiderstand besitzt.

2. Mikromechanische Vorrichtung, mit: wenigstens einer Adressenelektrode (10) auf einem Substrat (20); wenigstens einer Landungselektrode (18) auf dem Substrat (20) in der Nähe der Adressenelektrode (10); einer Trägerschicht, die auf dem Substrat (20) in der Weise gebildet ist, daß in der Schicht wenigstens ein Spalt vorhanden ist, der die Adressenelektrode (10) und die Landungselektrode (18) freilegt; wenigstens einem Scharnier, das auf der Trägerschicht in der Weise ausgebildet, daß das Scharnier (14) über dem Spalt aufgehängt ist; wenigstens einem Ablenkelement (12), das auf dem wenigstens einem Scharnier (14) ausgebildet ist, wobei das Ablenkelement (12) so positioniert ist, daß es über dem Spalt hängt; wobei die Vorrichtung ferner gekennzeichnet ist durch:
eine orientierte Einzelschicht aus Perfluordecansäure (PFDA), die auf der Landungselektrode (38) und dem ablenkbaren Element (36) gebildet ist, so daß, wenn die Adressenelektrode aktiviert wird und das Ablenkelement sich um das Scharnier dreht und die Landungselektrode berührt, die Landungselektrode und das Ablenkelement nicht aneinander haften, wobei die Einzelschicht nicht verschleißt und nicht an der Landungselektrode und am ablenkbaren Element kratzt.

## Revendications

1. Procédé de formation d'un revêtement protecteur sur un dispositif micromécanique, comprenant les étapes consistant à : fabriquer un dispositif micromécanique ayant un élément qui peut être défléchi (12) suspendu à des articulations (14) par dessus au moins une électrode d'adresse (10) et au moins une électrode de réception (18), de telle manière que, quand ladite électrode d'adresse (10) est activée, ledit élément qui peut être défléchi (12) est défléchi et repose sur l'électrode de réception (18); déposer ledit revêtement protecteur sur ladite électrode de réception (38) et ledit élément qui peut être défléchi (36) dudit dispositif micromécanique pour éviter la friction entre ladite électrode de réception (38) et ledit élément qui peut être défléchi (36) dudit dispositif, caractérisé en ce qu'avant l'étape de dépôt, la surface à couvrir est activée en plaçant le dispositif dans un plasma d'oxygène puis chauffée et ledit revêtement protecteur est formé par évaporation sous vide d'acide perfluorodécanoïque (PFDA) afin de former une couche monomoléculaire orientée qui empêche la friction et est dotée d'une grande résistance à l'usure et à l'abrasion.

2. Dispositif micromécanique comprenant : au moins une électrode d'adresse (10) sur un substrat (20); au moins une électrode de réception (18) sur ledit substrat (20) adjacente à ladite électrode d'adresse (10); une couche de support formée sur ledit substrat (20) de telle manière qu'au moins une ouverture existe dans ladite couche découvrant ladite électrode d'adresse (10) et ladite électrode de réception (18); au moins une articulation (14) formée sur ladite couche de support de telle manière que ladite articulation (14) est suspendue par dessus ladite ouverture; au moins un élément de déflexion (12) élaboré sur ladite au moins première articulation (14), dans lequel ledit élément de déflexion (12) est positionné pour être suspendu au-dessus de ladite ouverture; ledit dispositif étant en outre caractérisé par une couche monomoléculaire orientée d'acide perfluorodécanoïque (PFDA) formée sur ladite électrode de réception (38) et sur ledit élément qui peut être défléchi (36), de telle manière que ladite électrode d'adresse est activée et que ledit élément de déflexion tourne autour de ladite articulation et touche ladite électrode de réception, que ladite électrode de réception et ledit élément de déflexion ne frottent pas l'un sur l'autre et que ladite couche monomoléculaire ne s'use pas ou n'est pas arrachée de ladite électrode de réception et dudit élément pouvant être défléchi.
